# FASCICULE DE BREVET EUROPEEN

(11) **EP 4 016 050 B1**
(45) Date de publication et mention de la délivrance du brevet: **07.05.2025**
(21) Numéro de dépôt: 21212983.7
(22) Date de dépôt: 07.12.2021
(51) Int. Cl.: G01N 21/21, G01N 21/64

(54) **DISPOSITIF COMPACT DE CARACTERISATION D'UNE SUBSTANCE PHOTOLUMINESCENTE**
KOMPAKTE VORRICHTUNG ZUR CHARAKTERISIERUNG EINER FOTOLUMINESZENTEN SUBSTANZ
COMPACT DEVICE FOR CHARACTERISING A PHOTOLUMINESCENT SUBSTANCE

(30) Priorité: 16.12.2020 FR 2013407
(43) Date de publication de la demande: 22.06.2022
(73) Titulaire: Commissariat à l'Energie Atomique et aux Energies Alternatives, 75015 Paris (FR)
(72) Inventeur: RACINE, Benoit, 38054 GRENOBLE Cedex 09 (FR); BLANDIN, Pierre, 38054 GRENOBLE Cedex 09 (FR); QUESNEL, Etienne, 38054 GRENOBLE Cedex 09 (FR)
(74) Mandataire: INNOV-GROUP

(56) Documents cités:
- WO-A1-2010/055308
- WO-A1-2010/100408
- KRAKER ELKE ET AL: "Integrated organic electronic based optochemical sensors using polarization filters", APPLIED PHYSICS LETTERS, A I P PUBLISHING LLC, US, vol. 92, no. 3, 23 January 2008 (2008-01-23), pages 33302 - 33302, XP012107887, ISSN: 0003-6951, DOI: 10.1063/1.2837410
- SAVVATE'EV V ET AL: "Integrated organic light-emitting device/fluorescence-based chemical sensors", APPLIED PHYSICS LETTERS, A I P PUBLISHING LLC, US, vol. 81, no. 24, 9 December 2002 (2002-12-09), pages 4652 - 4654, XP012032780, ISSN: 0003-6951, DOI: 10.1063/1.1518154

## Description

### Domaine technique

L'invention se rapporte au domaine technique de la caractérisation optique d'une substance photoluminescente, par détection du rayonnement de photoluminescence émis par la substance.

L'invention trouve notamment son application dans la détection et l'imagerie en biologie, et plus généralement dans le domaine de la santé.

### État de l'art

Un ensemble de caractérisation d'une substance pouvant émettre un rayonnement de photoluminescence dans une première gamme spectrale, connu de l'état de la technique, comporte :
- un contenant, destiné à recevoir la substance, et comprenant des première et deuxième parois opposées ;
- un composant électroluminescent, agencé sur la première paroi pour émettre un rayonnement d'excitation dans une deuxième gamme spectrale adapté pour exciter la substance de sorte que la substance puisse émettre le rayonnement de photoluminescence ;
- un filtre spectral (e.g. interférentiel), agencé sur la deuxième paroi pour bloquer le rayonnement d'excitation sortant de la deuxième paroi et laisser passer le rayonnement de photoluminescence ;
- un détecteur, agencé pour détecter le rayonnement de photoluminescence sortant du filtre spectral, le détecteur pouvant être un imageur.

Le rayonnement de photoluminescence est de beaucoup plus faible intensité que le rayonnement d'excitation, typiquement un photon est émis par la substance pour 10⁶ photons émis par le composant électroluminescent. Le filtre spectral doit donc posséder un fort taux de réjection dans la deuxième gamme spectrale, avec une valeur de transmission de l'ordre de 10⁻⁶. Le filtre spectral utilisé peut être un filtre interférentiel à structure multicouche complexe, comportant plusieurs dizaines de monocouches d'indices optiques différents.

Un tel ensemble de l'état de la technique n'est pas entièrement satisfaisant dans la mesure où :
- il est peu compact puisque le composant électroluminescent et le détecteur sont situés de part et d'autre du contenant,
- un tel filtre interférentiel est complexe et fortement contraint mécaniquement, ce qui le rend difficile à intégrer directement au détecteur (ou à l'imageur) pour gagner en compacité.

Des dispositifs similaires connus de l'état de l'art sont décrits dans la publication "Integrated organic electronic based optochemical sensors using polarization filters", de Kraker Elke et al., APPLIED PHYSICS LETTERS, A I P PUBLISHING LLC, US, vol. 92, no. 3, 23 janvier 2008 (2008-01-23), pages 33302-33302, ou dans la publication "Integrated organic light-emitting device/fluorescence-based chemical sensors", de Savvate'ev V. et al, APPLIED PHYSICS LETTERS, A I P PUBLISHING LLC, US, vol. 81, no. 24, 9 décembre 2002 (2002-12-09), pages 4652-4654.

### Exposé de l'invention

L'invention vise à remédier en tout ou partie aux inconvénients précités. A cet effet, l'invention a pour objet un dispositif de caractérisation d'une substance pouvant émettre un rayonnement de photoluminescence dans une première gamme spectrale, le dispositif comportant :
- un composant électroluminescent, au moins semi-transparent dans la première gamme spectrale, et comprenant des première et deuxième surfaces opposées, la première surface étant destinée à être orientée vers la substance, le composant électroluminescent étant adapté pour émettre un rayonnement d'excitation sortant des première et deuxième surfaces, le rayonnement d'excitation étant émis dans une deuxième gamme spectrale selon un état de polarisation circulaire, le rayonnement d'excitation étant adapté pour exciter la substance de sorte que la substance puisse émettre le rayonnement de photoluminescence ;
- un filtre de polarisation, agencé pour filtrer le rayonnement d'excitation sortant de la deuxième surface du composant électroluminescent, et adapté pour modifier l'état de polarisation circulaire de manière à obtenir une extinction du rayonnement d'excitation sortant de la deuxième surface du composant électroluminescent ;
- un détecteur, agencé pour détecter le rayonnement de photoluminescence sortant du filtre de polarisation.

### Définitions

- Par « photoluminescence », on entend le phénomène par lequel la substance absorbe des photons dans la deuxième gamme spectrale du rayonnement d'excitation, et réémet des photons dans la première gamme spectrale (décalée vers de plus hautes longueurs d'onde). Le terme « photoluminescence » couvre la fluorescence et la phosphorescence.
- Par « au moins semi-transparent », on entend que le composant électroluminescent est semi-transparent ou transparent dans la première gamme spectrale. Par « semi-transparent », on entend que le composant électroluminescent possède un coefficient de transmission en intensité, moyenné sur la première gamme spectrale, compris entre 30% et 70%, de préférence compris entre 40% et 70%, plus préférentiellement compris entre 50% et 70%. Par « transparent », on entend que le composant électroluminescent possède un coefficient de transmission en intensité, moyenné sur la première gamme spectrale, supérieur ou égal à 70%, de préférence supérieur ou égal à 80%, plus préférentiellement supérieur ou égal à 90%.
- Le terme « état de polarisation circulaire » peut également couvrir un état de polarisation en toute rigueur elliptique lorsque les composantes transverses du champ électrique (ou magnétique) sont très légèrement différentes en intensité lors de la propagation du rayonnement d'excitation.

Ainsi, un tel dispositif selon l'invention permet de s'affranchir d'un filtre interférentiel, difficilement intégrable à un détecteur (ou imageur), pour réduire fortement l'intensité du rayonnement d'excitation franchissant le détecteur. Pour ce faire, le composant électroluminescent est adapté pour émettre un rayonnement d'excitation polarisé circulairement, et est associé à un filtre de polarisation modifiant l'état de polarisation circulaire pour obtenir une extinction du rayonnement d'excitation sortant de la deuxième surface du composant électroluminescent, et destiné à être absorbé par le détecteur. Un tel filtre de polarisation peut être aisément intégré au détecteur et au composant électroluminescent. Par conséquent, le composant électroluminescent et le détecteur peuvent alors être situés d'un seul côté d'un contenant de la substance, afin de gagner en compacité par rapport à l'état de la technique. Un tel dispositif selon l'invention permet donc, par exemple, de caractériser la substance en épifluorescence.

Le dispositif selon l'invention peut comporter une ou plusieurs des caractéristiques suivantes.

Selon une caractéristique de l'invention, le filtre de polarisation comporte :
- une lame quart d'onde, agencée pour modifier l'état de polarisation circulaire du rayonnement d'excitation sortant de la deuxième surface du composant électroluminescent en un état de polarisation linéaire possédant une première direction de polarisation ;
- un polariseur linéaire, possédant un axe de polarisation perpendiculaire à la première direction de polarisation, et agencé pour obtenir l'extinction du rayonnement d'excitation sortant de la lame quart d'onde.

Ainsi, un avantage procuré est de couper intégralement le rayonnement d'excitation sortant de la deuxième surface du composant électroluminescent. En revanche, le rayonnement de photoluminescence n'est pas totalement bloqué par un tel filtre de polarisation. En effet, le détecteur détecte une composante (selon l'axe de polarisation du polariseur linéaire) du rayonnement de photoluminescence sortant du filtre de polarisation. Le rayonnement de photoluminescence n'a généralement pas d'état de polarisation privilégié (i.e. est non polarisé), ou bien alors le rayonnement de photoluminescence présente un état de polarisation qui est distinct de l'état de polarisation circulaire du rayonnement d'excitation, par exemple un état de polarisation linéaire, de sorte que le détecteur détecte toujours une composante du rayonnement de photoluminescence selon l'axe de polarisation du polariseur linéaire. Plus précisément, lorsque le rayonnement de photoluminescence présente un état de polarisation linéaire, la lame quart d'onde introduit un déphasage de 90°, et le rayonnement de photoluminescence sort de la lame quart d'onde avec un état de polarisation elliptique, si bien que le détecteur peut détecter une composante du rayonnement de photoluminescence selon l'axe de polarisation du polariseur linéaire.

Selon une caractéristique de l'invention, la substance comporte plusieurs types d'éléments pouvant émettre le rayonnement de photoluminescence à des longueurs d'onde distinctes prédéterminées ; et le dispositif comporte des filtres spectraux optiques, adaptés pour filtrer le rayonnement de photoluminescence aux longueurs d'onde distinctes prédéterminées, et agencés entre le filtre de polarisation et le détecteur, les filtres spectraux optiques étant de préférence des filtres colorés agencés en matrice de Bayer.

Ainsi, un avantage procuré par les filtres spectraux optiques est de pouvoir discriminer différents types d'éléments qui réémettent à des longueurs d'ondes distinctes dans la première gamme spectrale, par exemple lorsque la substance comporte des boîtes quantiques (« *Quantum dots»* en langue anglaise) fluorescentes. Les différents types d'éléments de la substance sont excités dans la deuxième gamme spectrale.

Ceci est rendu possible grâce à l'extinction du rayonnement d'excitation sortant de la deuxième surface du composant électroluminescent par le filtre de polarisation, autorisant une réduction des contraintes en termes de densité optique pour les filtres spectraux optiques. Les filtres spectraux optiques utilisés pourront présenter une densité optique comprise entre 1 et 2, alors qu'une densité optique supérieure à 6 serait nécessaire pour bloquer le rayonnement d'excitation sortant de la deuxième surface du composant électroluminescent en l'absence de filtre de polarisation. Or, un filtre possédant une densité optique supérieure à 6 n'est pas du tout adapté au filtrage (tri) de couleurs.

Selon une caractéristique de l'invention, le composant électroluminescent est choisi parmi :
- un composant électroluminescent organique, comprenant de préférence des diodes électroluminescentes organiques ;
- un composant électroluminescent inorganique, comprenant de préférence des diodes électroluminescentes de type spin-LED.

Selon une caractéristique de l'invention, le détecteur comporte des photodiodes.

Selon une caractéristique de l'invention, le rayonnement d'excitation est adapté pour exciter la substance comportant des éléments choisis parmi des boîtes quantiques fluorescentes et des fluorophores organiques.

L'invention a également pour objet un système de caractérisation d'une substance pouvant émettre un rayonnement de photoluminescence dans une première gamme spectrale, le système comportant :
- un dispositif conforme à l'invention ;
- une paroi de séparation, destinée à séparer la substance et le dispositif, la paroi de séparation étant au moins semi-transparente dans les première et deuxième gammes spectrales ;
la première surface du composant électroluminescent étant montée sur la paroi de séparation.

### Définition

Par « au moins semi-transparente », on entend que la paroi de séparation est semi-transparente ou transparente dans les première et deuxième gammes spectrales. Par « semi-transparente », on entend que la paroi de séparation possède un coefficient de transmission en intensité, moyenné sur chacune des première et deuxième gammes spectrales, compris entre 30% et 70%, de préférence compris entre 40% et 70%, plus préférentiellement compris entre 50% et 70%. Par « transparente », on entend que la paroi de séparation possède un coefficient de transmission en intensité, moyenné sur chacune des première et deuxième gammes spectrales, supérieur ou égal à 70%, de préférence supérieur ou égal à 80%, plus préférentiellement supérieur ou égal à 90%.

L'invention a également pour objet un ensemble de caractérisation d'une substance pouvant émettre un rayonnement de photoluminescence dans une première gamme spectrale, l'ensemble comportant :
- un dispositif conforme à l'invention ;
- un contenant, destiné à recevoir la substance, et comprenant des première et deuxième parois opposées au moins semi-transparentes dans les première et deuxième gammes spectrales ; la première surface du composant électroluminescent étant montée sur la première paroi ;
- un absorbeur, agencé sur la deuxième paroi, et adapté pour absorber le rayonnement d'excitation sortant de la première surface du composant électroluminescent et traversant les première et deuxième parois.

### Définitions

- Par « au moins semi-transparentes », on entend que les première et deuxième parois sont semi-transparentes ou transparentes dans les première et deuxième gammes spectrales. Par « semi-transparentes », on entend que les première et deuxième parois possèdent un coefficient de transmission en intensité, moyenné sur chacune des première et deuxième gammes spectrales, compris entre 30% et 70%, de préférence compris entre 40% et 70%, plus préférentiellement compris entre 50% et 70%. Par « transparentes », on entend que les première et deuxième parois possèdent un coefficient de transmission en intensité, moyenné sur chacune des première et deuxième gammes spectrales, supérieur ou égal à 70%, de préférence supérieur ou égal à 80%, plus préférentiellement supérieur ou égal à 90%.

Ainsi, un avantage procuré par l'absorbeur est d'empêcher une réflexion du rayonnement d'excitation sortant de la première surface du composant électroluminescent et traversant les première et deuxième parois. Une telle réflexion en incidence normale serait préjudiciable car elle inverserait l'état de polarisation circulaire du rayonnement d'excitation (passage d'un état circulaire droit à circulaire gauche, ou inversement), et rendrait le filtre de polarisation inopérant pour une partie du rayonnement d'excitation sortant de la deuxième surface du composant électroluminescent, après avoir subi une réflexion et après avoir traversé le composant électroluminescent, de la première surface vers la deuxième surface.

L'invention a également pour objet un ensemble de caractérisation d'une substance pouvant émettre un rayonnement de photoluminescence dans une première gamme spectrale, l'ensemble comportant :
- un dispositif conforme à l'invention ;
- un contenant, destiné à recevoir la substance, et comprenant des première et deuxième parois opposées au moins semi-transparentes dans les première et deuxième gammes spectrales ; la première surface du composant électroluminescent étant montée sur la première paroi ;
- un filtre de polarisation additionnel, agencé pour filtrer le rayonnement d'excitation sortant de la deuxième paroi, et adapté pour modifier l'état de polarisation circulaire de manière à obtenir une extinction du rayonnement d'excitation sortant de la deuxième paroi ;
- un détecteur additionnel, agencé pour détecter le rayonnement de photoluminescence sortant du filtre de polarisation additionnel.

Ainsi, un avantage procuré est d'assurer une double détection du rayonnement de photoluminescence de part et d'autre du contenant.

### Brève description des dessins

D'autres caractéristiques et avantages apparaîtront dans l'exposé détaillé de différents modes de réalisation de l'invention, l'exposé étant assorti d'exemples et de références aux dessins joints.
Figure 1 est une vue schématique en coupe illustrant le fonctionnement d'un dispositif selon l'invention.
Figure 2 est une vue schématique en coupe d'un dispositif selon l'invention, équipant un contenant muni de la substance à caractériser.
Figure 3 est une vue schématique correspondant à la figure 2, où l'encart est une vue en coupe à l'échelle agrandie du composant électroluminescent.
Figure 4 est une vue schématique en coupe d'un dispositif selon l'invention, illustrant la présence de filtres optiques du rayonnement de photoluminescence.
Figure 5 est une vue schématique en coupe d'un système selon l'invention, équipant un contenant muni de la substance à caractériser.
Figure 6 est une vue schématique en coupe d'un ensemble selon l'invention, où une paroi du contenant est munie d'un absorbeur.
Figure 7 est une vue schématique en coupe d'un ensemble selon l'invention, où une paroi du contenant est munie d'un filtre de polarisation additionnel et d'un détecteur additionnel.

Il est à noter que les dessins décrits ci-avant sont schématiques, et ne sont pas à l'échelle par souci de lisibilité et pour en simplifier leur compréhension.

### Exposé détaillé des modes de réalisation

Les éléments identiques ou assurant la même fonction porteront les mêmes références pour les différents modes de réalisation, par souci de simplification.

Un objet de l'invention est un dispositif 1 de caractérisation d'une substance 2 pouvant émettre un rayonnement de photoluminescence Rp dans une première gamme spectrale, le dispositif 1 comportant :
- un composant 3 électroluminescent, au moins semi-transparent dans la première gamme spectrale, et comprenant des première et deuxième surfaces 30, 31 opposées, la première surface 30 étant destinée à être orientée vers la substance 2, le composant 3 électroluminescent étant adapté pour émettre un rayonnement d'excitation Re₁, Re₂ sortant des première et deuxième surfaces 30, 31, le rayonnement d'excitation Re₁, Re₂ étant émis dans une deuxième gamme spectrale selon un état de polarisation circulaire, le rayonnement d'excitation Re₁ étant adapté pour exciter la substance 2 de sorte que la substance 2 puisse émettre le rayonnement de photoluminescence Rp ;
- un filtre de polarisation 4, agencé pour filtrer le rayonnement d'excitation Re₂ sortant de la deuxième surface 31 du composant 3 électroluminescent, et adapté pour modifier l'état de polarisation circulaire de manière à obtenir une extinction du rayonnement d'excitation Re₂ sortant de la deuxième surface 31 du composant 3 électroluminescent ;
- un détecteur 5, agencé pour détecter le rayonnement de photoluminescence Rp sortant du filtre de polarisation 4.

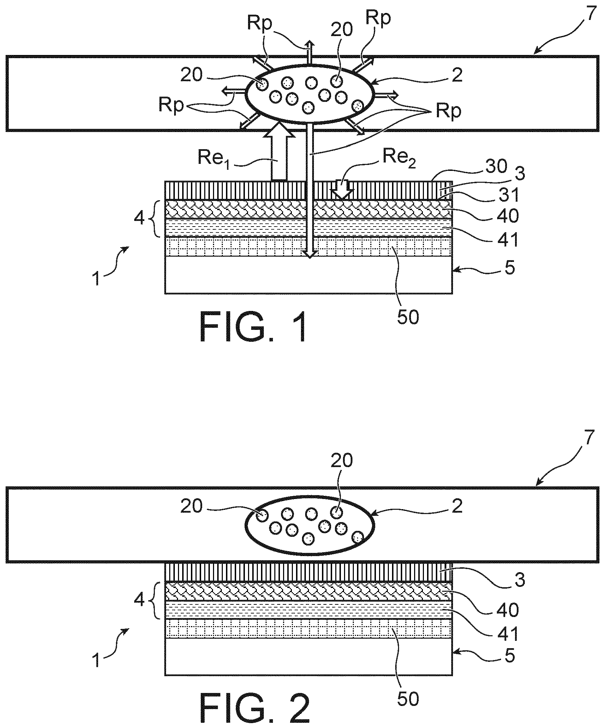

Le principe de fonctionnement du dispositif 1 est illustré à la figure 1. Le dispositif 1 en position de fonctionnement est illustré à la figure 2.

### Composant électroluminescent

Le composant 3 électroluminescent est avantageusement choisi parmi :
- un composant 3 électroluminescent organique, comprenant de préférence des diodes électroluminescentes organiques ;
- un composant 3 électroluminescent inorganique, comprenant de préférence des diodes électroluminescentes de type spin-LED.

Les diodes électroluminescentes organiques du composant 3 électroluminescent organique sont avantageusement du type CP-OLED (*« Circularly-Polarized Organic Light-Emitting Diodes »* en langue anglaise).

Les première et deuxième surfaces 30, 31 du composant 3 électroluminescent sont avantageusement des surfaces planes.

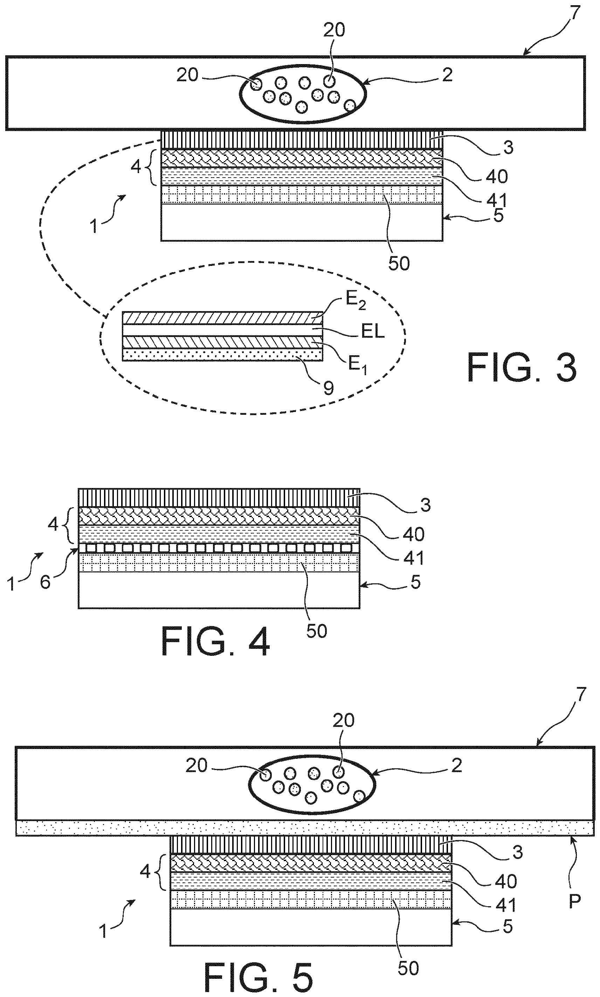

Comme illustré à la figure 3, le composant 3 électroluminescent comporte :
- des première et seconde électrodes E₁, E₂, au moins semi-transparentes dans les première et deuxième gammes spectrales ; la seconde électrode E₂ étant destinée à être orientée vers la substance 2 ;
- une couche électroluminescente EL, adaptée pour émettre le rayonnement d'excitation polarisé circulairement.

Le composant 3 électroluminescent organique comporte avantageusement une couche d'encapsulation 9, agencée pour protéger le composant 3 électroluminescent organique de l'air et de l'humidité. La couche d'encapsulation 9 est préférentiellement transparente dans les première et deuxième gammes spectrales de manière à ne pas affecter le rayonnement la traversant.

La première électrode E₁ peut être réalisée dans un matériau métallique, tel que Ag, Al, Au, ou plus généralement tout métal pouvant être déposé par une technique d'évaporation. La première électrode E₁ peut être semi-transparente dans les première et deuxième gammes spectrales. La seconde électrode E₂ peut être réalisée en oxyde d'indium-étain (ITO pour « *Indium Tin Oxide* » en langue anglaise). La seconde électrode E₂ peut être semi-transparente ou transparente dans les première et deuxième gammes spectrales. Les première et seconde électrodes E₁, E₂ peuvent être réalisées dans un oxyde transparent conducteur.

La couche électroluminescente EL peut être organique. La couche électroluminescente EL organique est avantageusement réalisée dans un matériau organique chiral. A titre d'exemples non limitatifs, le matériau organique chiral peut être :
- un hélicène, tel qu'un platinahélicène,
- le poly(fluorène-alt-benzothiadiazole) chiral (c-PFBT) -où « alt » désigne un copolymère alterné-,
- un complexe de lanthanides,
- un complexe d'iridium (III).

D'autres exemples de matériaux organiques adaptés pour émettre un rayonnement électromagnétique polarisé circulairement sont donnés dans le document J. Han et al., « Recent Progress on Circularly Polarized Luminescent Materials for Organic Optoelectronic Devices », Advanced Optical Materials, vol. 6, 17, 2018.

Selon une alternative, la couche électroluminescente EL peut être inorganique de manière à obtenir une diode électroluminescente de type spin-LED. A titre d'exemples non limitatifs, la couche électroluminescente EL inorganique peut être réalisée sous la forme d'un puits quantique, par exemple InGaN/GaN ou AlGaAs/GaAs. Le cas échéant, la seconde électrode E₂ est réalisée dans un matériau magnétique de manière à polariser circulairement la lumière émise par la couche électroluminescente EL inorganique, le matériau magnétique pouvant être par exemple MgO/FeCo.

Le rayonnement électromagnétique émis par la couche électroluminescente EL peut posséder une longueur d'onde dominante. Le domaine spectral du rayonnement électromagnétique émis par la couche électroluminescente EL (i.e. la deuxième gamme spectrale) est avantageusement choisi parmi :
- le domaine visible avec des longueurs d'onde comprises entre 400 nm et 780 nm,
- le domaine UV-A avec des longueurs d'onde comprises entre 315 nm et 400 nm,
- le domaine infrarouge proche avec des longueurs d'onde comprises entre 780 nm et 3 µm.

On choisira un domaine spectral en fonction de la nature de la substance 2 de sorte que le domaine spectral se situe dans la bande d'absorption de la substance 2.

La couche électroluminescente EL n'est préférentiellement pas en contact avec les première et seconde électrodes E₁, E₂. Le composant 3 électroluminescent peut par exemple comporter des couches de transport (d'électrons et de trous) et des couches d'injection (d'électrons et de trous) s'étendant entre une électrode E₁, E₂ et la couche électroluminescente EL (dite couche émissive).

### Filtre de polarisation

Le filtre de polarisation 4 comporte avantageusement :
- une lame quart d'onde 40, agencée pour modifier l'état de polarisation circulaire du rayonnement d'excitation Re₂ sortant de la deuxième surface 31 du composant 3 électroluminescent en un état de polarisation linéaire possédant une première direction de polarisation ;
- un polariseur linéaire 41, possédant un axe de polarisation perpendiculaire à la première direction de polarisation, et agencé pour obtenir l'extinction du rayonnement d'excitation sortant de la lame quart d'onde 40.

En d'autres termes, le polariseur linéaire 41 est croisé de sorte qu'il n'existe pas d'onde d'excitation sortante. Le rayonnement d'excitation Re₂ sort de la lame quart d'onde 40 avec un état de polarisation linéaire, la lame quart d'onde 40 introduisant un déphasage de 90°. La première direction de polarisation présente un angle de +45° (respectivement -45°) avec l'axe lent de la lame quart d'onde 40 lorsque le rayonnement d'excitation Re₂ possède initialement une polarisation circulaire gauche (respectivement circulaire droite). L'axe de polarisation du polariseur linéaire 41 est orienté en formant un angle de -45° (respectivement +45°) avec l'axe lent de la lame quart d'onde 40 lorsque le rayonnement d'excitation Re₂ possède initialement une polarisation circulaire gauche (respectivement circulaire droite).

### Détecteur

Le détecteur 5 comporte avantageusement des photodiodes 50, pouvant appartenir à un capteur d'images.

Lorsque la substance 2 comporte plusieurs types d'éléments 20 pouvant émettre le rayonnement de photoluminescence Rp à des longueurs d'onde distinctes prédéterminées, le dispositif 1 peut comporter des filtres spectraux optiques 6 (illustrés à la figure 4), adaptés pour filtrer le rayonnement de photoluminescence Rp aux longueurs d'onde distinctes prédéterminées, et agencés entre le filtre de polarisation 4 et le détecteur 5. Les filtres spectraux optiques 6 sont de préférence des filtres colorés agencés en matrice de Bayer.

### Substance à caractériser

Le rayonnement d'excitation Re₁ peut être adapté pour exciter la substance 2 comportant des éléments 20 choisis parmi des boîtes quantiques fluorescentes et des fluorophores organiques. La substance 2 peut posséder une fluorescence intrinsèque, comme certaines protéines ou certains pigments tels que la chlorophylle. La substance 2 peut comporter des luminophores/fluorophores intégrés à la substance 2. La substance 2 peut être une protéine, une cellule dont l'ADN est marqué à l'aide d'un luminophore, une cellule génétiquement modifiée pour être fluorescente etc.

Le rayonnement de photoluminescence Rp de la substance 2 est non polarisé, ou présente un état de polarisation distinct de l'état de polarisation circulaire du rayonnement d'excitation Re₁, Re₂ émis par le composant 3 électroluminescent.

### Système de caractérisation

Comme illustré à la figure 5, un objet de l'invention est un système de caractérisation d'une substance 2 pouvant émettre un rayonnement de photoluminescence Rp dans une première gamme spectrale, le système comportant :
- un dispositif 1 conforme à l'invention ;
- une paroi de séparation P, destinée à séparer la substance 2 et le dispositif 1, la paroi de séparation P étant au moins semi-transparente dans les première et deuxième gammes spectrales ;
la première surface 30 du composant 3 électroluminescent étant montée sur la paroi de séparation P.

Comme illustré à la figure 5, la paroi de séparation P est agencée pour recouvrir un contenant 7, destiné à recevoir la substance 2.

Le composant 3 électroluminescent du dispositif 1, lorsque celui-ci comporte des diodes électroluminescentes organiques, peut être formé sur la paroi de séparation P par des techniques de dépôt connues de l'homme du métier. Le filtre de polarisation 4 du dispositif 1 peut être formé sur le composant 3 électroluminescent par laminage, puis le détecteur 5 est monté sur le filtre de polarisation 4.

### Ensemble de caractérisation : premier mode de réalisation

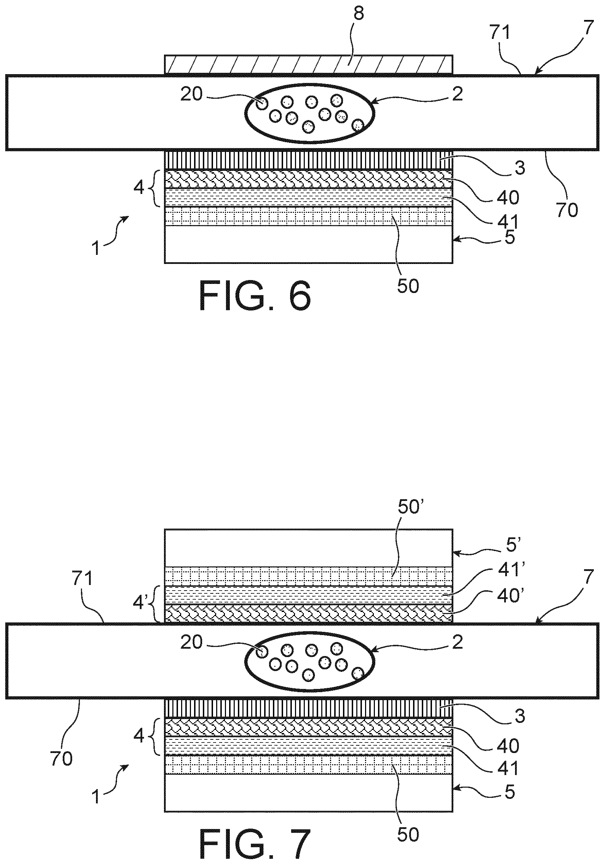

Comme illustré à la figure 6, un objet de l'invention est un ensemble de caractérisation d'une substance 2 pouvant émettre un rayonnement de photoluminescence Rp dans une première gamme spectrale, l'ensemble comportant :
- un dispositif 1 conforme à l'invention ;
- un contenant 7, destiné à recevoir la substance 2, et comprenant des première et deuxième parois 70, 71 opposées au moins semi-transparentes dans les première et deuxième gammes spectrales ; la première surface 30 du composant 3 électroluminescent étant montée sur la première paroi 70 ;
- un absorbeur 8, agencé sur la deuxième paroi 71, et adapté pour absorber le rayonnement d'excitation Re₁ sortant de la première surface 30 du composant 3 électroluminescent et traversant les première et deuxième parois 70, 71.

L'absorbeur 8 peut être réalisé dans un matériau opaque dans la deuxième gamme spectrale. A titre d'exemples non limitatifs, le matériau opaque dans la deuxième gamme spectrale peut être choisi parmi :
- une résine noire,
- le graphite ou un carbone amorphe,
- un matériau composite comportant une matrice métallique et un renfort en céramique, tel que Al/SiO₂ et Ag/WO₃.

L'absorbeur 8 peut également être réalisé sous la forme d'une couche anti-reflet.

L'absorbeur 8 est avantageusement couplé à un élément réfléchissant (non illustré), agencé pour réfléchir le rayonnement de photoluminescence Rp. Un tel élément réfléchissant permet au détecteur 5 de collecter le rayonnement de photoluminescence Rp avec une intensité plus élevée. Par « élément réfléchissant », on entend que l'élément possède un coefficient de réflexion en intensité, moyenné sur la première gamme spectrale, supérieur ou égal à 70%, de préférence supérieur ou égal à 80%, plus préférentiellement supérieur ou égal à 90%. L'élément réfléchissant peut être un filtre interférentiel. L'élément réfléchissant est transparent dans la deuxième gamme spectrale. L'élément réfléchissant peut être interposé entre la deuxième paroi 71 et l'absorbeur 8.

Le composant 3 électroluminescent du dispositif 1, lorsque celui-ci comporte des diodes électroluminescentes organiques, peut être formé sur la première paroi 70 par des techniques de dépôt connues de l'homme du métier. Le filtre de polarisation 4 du dispositif 1 peut être formé sur le composant 3 électroluminescent par laminage, puis le détecteur 5 est monté sur le filtre de polarisation 4.

### Ensemble de caractérisation : deuxième mode de réalisation

Comme illustré à la figure 7, un objet de l'invention est un ensemble de caractérisation d'une substance 2 pouvant émettre un rayonnement de photoluminescence Rp dans une première gamme spectrale, l'ensemble comportant :
- un dispositif 1 conforme à l'invention ;
- un contenant 7, destiné à recevoir la substance 2, et comprenant des première et deuxième parois 70, 71 opposées au moins semi-transparentes dans les première et deuxième gammes spectrales ; la première surface 30 du composant 3 électroluminescent étant montée sur la première paroi 70 ;
- un filtre de polarisation additionnel 4', agencé pour filtrer le rayonnement d'excitation sortant de la deuxième paroi 71, et adapté pour modifier l'état de polarisation circulaire de manière à obtenir une extinction du rayonnement d'excitation sortant de la deuxième paroi 71 ;
- un détecteur additionnel 5', agencé pour détecter le rayonnement de photoluminescence Rp sortant du filtre de polarisation additionnel 4'.

Le filtre de polarisation additionnel 4' comporte avantageusement :
- une lame quart d'onde 40' additionnelle, agencée pour modifier l'état de polarisation circulaire du rayonnement d'excitation sortant de la deuxième paroi 71 en un état de polarisation linéaire possédant une première direction de polarisation ;
- un polariseur linéaire 41' additionnel, possédant un axe de polarisation perpendiculaire à la première direction de polarisation, et agencé pour obtenir l'extinction du rayonnement d'excitation sortant de la lame quart d'onde 40' additionnelle.

Le composant 3 électroluminescent du dispositif 1, lorsque celui-ci comporte des diodes électroluminescentes organiques, peut être formé sur la première paroi 70 par des techniques de dépôt connues de l'homme du métier. Le filtre de polarisation 4 du dispositif 1 peut être formé sur le composant 3 électroluminescent par laminage, puis le détecteur 5 est monté sur le filtre de polarisation 4. Le filtre de polarisation additionnel 4' peut être formée sur la deuxième paroi 71 par laminage, puis le détecteur additionnel 5' est monté sur le filtre de polarisation additionnel 4'.

## Revendications

1. Dispositif (1) de caractérisation d'une substance (2) pouvant émettre un rayonnement de photoluminescence (Rp) dans une première gamme spectrale, le dispositif (1) comportant :
- un composant (3) électroluminescent, au moins semi-transparent dans la première gamme spectrale, et comprenant des première et deuxième surfaces (30, 31) opposées, la première surface (30) étant destinée à être orientée vers la substance (2), le composant (3) électroluminescent étant adapté pour émettre un rayonnement d'excitation (Re₁, Re₂) sortant des première et deuxième surfaces (30, 31), le rayonnement d'excitation (Re₁, Re₂) étant émis dans une deuxième gamme spectrale selon un état de polarisation circulaire, le rayonnement d'excitation (Re₁) étant adapté pour exciter la substance (2) de sorte que la substance (2) puisse émettre le rayonnement de photoluminescence (Rp) ;
- un filtre de polarisation (4) associé au composant (3) électroluminescent, agencé pour filtrer le rayonnement d'excitation (Re₂) sortant de la deuxième surface (31) du composant (3) électroluminescent, et adapté pour modifier l'état de polarisation circulaire de manière à obtenir une extinction du rayonnement d'excitation (Re₂) sortant de la deuxième surface (31) du composant (3) électroluminescent ;
- un détecteur (5), agencé pour détecter le rayonnement de photoluminescence (Rp) sortant du filtre de polarisation (4), le composant (3) électroluminescent et le détecteur (5) étant situés d'un seul côté de la substance.

2. Dispositif (1) selon la revendication 1, dans lequel le filtre de polarisation (4) comporte :
- une lame quart d'onde (40), agencée pour modifier l'état de polarisation circulaire du rayonnement d'excitation (Re₂) sortant de la deuxième surface (31) du composant (3) électroluminescent en un état de polarisation linéaire possédant une première direction de polarisation ;
- un polariseur linéaire (41), possédant un axe de polarisation perpendiculaire à la première direction de polarisation, et agencé pour obtenir l'extinction du rayonnement d'excitation (Re₂) sortant de la lame quart d'onde (40).

3. Dispositif (1) selon la revendication 1 ou 2, dans lequel la substance (2) comporte plusieurs types d'éléments (20) pouvant émettre le rayonnement de photoluminescence (Rp) à des longueurs d'onde distinctes prédéterminées ; et le dispositif (1) comporte des filtres spectraux optiques (6), adaptés pour filtrer le rayonnement de photoluminescence (Rp) aux longueurs d'onde distinctes prédéterminées, et agencés entre le filtre de polarisation (4) et le détecteur (5), les filtres spectraux optiques (6) étant de préférence des filtres colorés agencés en matrice de Bayer.

4. Dispositif (1) selon l'une des revendications 1 à 3, dans lequel le composant (3) électroluminescent est choisi parmi :
- un composant (3) électroluminescent organique, comprenant de préférence des diodes électroluminescentes organiques ;
- un composant (3) électroluminescent inorganique, comprenant de préférence des diodes électroluminescentes de type spin-LED.

5. Dispositif (1) selon l'une des revendications 1 à 4, dans lequel le détecteur (5) comporte des photodiodes (50).

6. Dispositif selon l'une des revendications 1 à 5, dans lequel le rayonnement d'excitation (Re₁) est adapté pour exciter la substance (2) comportant des éléments (20) choisis parmi des boîtes quantiques fluorescentes et des fluorophores organiques.

7. Système de caractérisation d'une substance (2) pouvant émettre un rayonnement de photoluminescence (Rp) dans une première gamme spectrale, le système comportant :
- un dispositif (1) selon l'une des revendications 1 à 6 ;
- une paroi de séparation (P), destinée à séparer la substance (2) et le dispositif (1), la paroi de séparation (P) étant au moins semi-transparente dans les première et deuxième gammes spectrales ;
la première surface (30) du composant (3) électroluminescent étant montée sur la paroi de séparation (P).

8. Ensemble de caractérisation d'une substance (2) pouvant émettre un rayonnement de photoluminescence (Rp) dans une première gamme spectrale, l'ensemble comportant :
- un dispositif (1) selon l'une des revendications 1 à 6 ;
- un contenant (7), destiné à recevoir la substance (2), et comprenant des première et deuxième parois (70, 71) opposées au moins semi-transparentes dans les première et deuxième gammes spectrales ; la première surface (30) du composant (3) électroluminescent étant montée sur la première paroi (70) ;
- un absorbeur (8), agencé sur la deuxième paroi (71), et adapté pour absorber le rayonnement d'excitation (Re₁) sortant de la première surface (30) du composant (3) électroluminescent et traversant les première et deuxième parois (70, 71).

9. Ensemble de caractérisation d'une substance (2) pouvant émettre un rayonnement de photoluminescence (Rp) dans une première gamme spectrale, l'ensemble comportant :
- un dispositif (1) selon l'une des revendications 1 à 6 ;
- un contenant (7), destiné à recevoir la substance (2), et comprenant des première et deuxième parois (70, 71) opposées au moins semi-transparentes dans les première et deuxième gammes spectrales ; la première surface (30) du composant (3) électroluminescent étant montée sur la première paroi (70) ;
- un filtre de polarisation additionnel (4'), agencé pour filtrer le rayonnement d'excitation sortant de la deuxième paroi (71), et adapté pour modifier l'état de polarisation circulaire de manière à obtenir une extinction du rayonnement d'excitation sortant de la deuxième paroi (71) ;
- un détecteur additionnel (5'), agencé pour détecter le rayonnement de photoluminescence (Rp) sortant du filtre de polarisation additionnel (4').

## Patentansprüche

1. Vorrichtung (1) zur Charakterisierung einer Substanz (2), die eine Photolumineszenz-Strahlung (Rp) in einem ersten Spektralbereich emittieren kann, die Vorrichtung (1) umfassend:
- eine elektrolumineszente Komponente (3), die in dem ersten Spektralbereich mindestens semitransparent ist und entgegengesetzte erste und zwei Flächen (30, 31) umfasst, wobei die erste Fläche (30) dazu bestimmt ist, zu der Substanz (2) hin gerichtet zu sein, wobei die elektrolumineszente Komponente (3) dazu angepasst ist, eine Anregungsstrahlung (Re₁, Re₂) zu emittieren, die aus den ersten und zweiten Flächen (30, 31) austritt, wobei die Anregungsstrahlung (Re₁, Re₂) in einem zweiten Spektralbereich gemäß einem zirkularen Polarisationszustand emittiert wird, wobei die Anregungsstrahlung (Re₁) dazu angepasst ist, die Substanz (2) anzuregen, so dass die Substanz (2) die Photolumineszenz-Strahlung (Rp) emittieren kann;
- ein Polarisationsfilter (4), das der elektrolumineszenten Komponente (3) zugeordnet ist, angeordnet ist, um die Anregungsstrahlung (Re₂), die aus der zweiten Fläche (31) der elektrolumineszenten Komponente (3) austritt, zu filtern, und dazu angepasst ist, den zirkularen Polarisationszustand so zu ändern, dass ein Abklingen der Anregungsstrahlung (Re₂), die aus der zweiten Fläche (31) der elektrolumineszenten Komponente (3) austritt, erhalten wird;
- einen Detektor (5), der angeordnet ist, um die aus dem Polarisationsfilter (4) austretende Photolumineszenz-Strahlung (Rp) zu detektieren, wobei die elektrolumineszente Komponente (3) und der Detektor (5) auf einer einzigen Seite der Substanz gelegen sind.

2. Vorrichtung (1) nach Anspruch 1, wobei das Polarisationsfilter (4) umfasst:
- ein Viertelwellenplättchen (40), das angeordnet ist, um den zirkularen Polarisationszustand der Anregungsstrahlung (Re₂), die aus der zweiten Fläche (31) der elektrolumineszenten Komponente (3) in einem linearen Polarisationszustand austritt und eine erste Polarisationsrichtung besitzt, zu ändern;
- einen Linearpolarisator (41), der eine Polarisationsachse besitzt, die senkrecht zu der ersten Polarisationsrichtung verläuft, und angeordnet ist, um das Abklingen der Anregungsstrahlung (Re₂), die aus dem Viertelwellenplättchen (40) austritt, zu erhalten.

3. Vorrichtung (1) nach Anspruch 1 oder 2, wobei die Substanz (2) mehrere Arten von Elementen (20) umfasst, die die Photolumineszenz-Strahlung (Rp) mit vorbestimmten verschiedenen Wellenlängen emittieren können; und wobei die Vorrichtung (1) optische Spektralfilter (6) umfasst, die dazu angepasst sind, die Photolumineszenz-Strahlung (Rp) mit den vorbestimmten verschiedenen Wellenlängen zu filtern, und zwischen dem Polarisationsfilter (4) und dem Detektor (5) angeordnet sind, wobei die optischen Spektralfilter (6) bevorzugt zu einer Bayer-Matrix angeordnete farbige Filter sind.

4. Vorrichtung (1) nach einem der Ansprüche 1 bis 3, wobei die elektrolumineszente Komponente (3) ausgewählt ist unter:
- einer organischen elektrolumineszenten Komponente (3), die bevorzugt organische Leuchtdioden aufweist;
- einer anorganischen elektrolumineszenten Komponente (3), die bevorzugt Leuchtdioden vom Typ spin-LED aufweist.

5. Vorrichtung (1) nach einem der Ansprüche 1 bis 4, wobei der Detektor (5) Fotodioden (50) umfasst.

6. Vorrichtung nach einem der Ansprüche 1 bis 5, wobei die Anregungsstrahlung (Re₁) dazu angepasst ist, die Substanz (2) anzuregen, die Elemente (20) umfasst, die unter fluoreszierenden Quantenpunkten und anorganischen Fluorophoren ausgewählt sind.

7. System zur Charakterisierung einer Substanz (2), die eine Photolumineszenz-Strahlung (Rp) in einem ersten Spektralbereich emittieren kann, das System umfassend:
- eine Vorrichtung (1) nach einem der Ansprüche 1 bis 6;
- eine Trennwand (P), die dazu bestimmt ist, die Substanz (2) und die Vorrichtung (1) zu trennen, wobei die Trennwand (P) in den ersten und zweiten Spektralbereichen mindestens semitransparent ist;
wobei die erste Fläche (30) der elektrolumineszenten Komponente (3) an der Trennwand (P) angebracht ist.

8. Anordnung zur Charakterisierung einer Substanz (2), die eine Photolumineszenz-Strahlung (Rp) in einem ersten Spektralbereich emittieren kann, die Anordnung umfassend:
- eine Vorrichtung (1) nach einem der Ansprüche 1 bis 6;
- einen Behälter (7), der dazu bestimmt ist, die Substanz (2) aufzunehmen, und entgegengesetzte erste und zweite Wände (70, 71) aufweist, die in den ersten und zweiten Spektralbereichen mindestens semitransparent sind; wobei die erste Fläche (30) der elektrolumineszenten Komponente (3) an der ersten Wand (70) angebracht ist;
- einen Absorber (8), der an der zweiten Wand (71) angeordnet ist und dazu angepasst ist, die Anregungsstrahlung (Re₁), die aus der ersten Fläche (30) der elektrolumineszenten Komponente (3) austritt und die ersten und zweiten Wände (70, 71) durchdringt, zu absorbieren.

9. Anordnung zur Charakterisierung einer Substanz (2), die eine Photolumineszenz-Strahlung (Rp) in einem ersten Spektralbereich emittieren kann, die Anordnung umfassend:
- eine Vorrichtung (1) nach einem der Ansprüche 1 bis 6;
- einen Behälter (7), der dazu bestimmt ist, die Substanz (2) aufzunehmen, und entgegengesetzte erste und zweite Wände (70, 71) aufweist, die in den ersten und zweiten Spektralbereichen mindestens semitransparent sind; wobei die erste Fläche (30) der elektrolumineszenten Komponente (3) an der ersten Wand (70) angebracht ist;
- ein zusätzliches Polarisationsfilter (4'), das angeordnet ist, um die Anregungsstrahlung, die aus der zweiten Wand (71) austritt, zu filtern, und dazu angepasst ist, den zirkularen Polarisationszustand so zu ändern, dass ein Abklingen der Anregungsstrahlung, die aus der zweiten Wand (71) austritt, erhalten wird;
- einen zusätzlichen Detektor (5'), der angeordnet ist, um die Photolumineszenz-Strahlung (Rp), die aus dem zusätzlichen Polarisationsfilter (4') austritt, zu detektieren.

## Claims

1. Device (1) for characterizing a substance (2) capable of emitting a photoluminescence radiation (Rp) in a first spectral range, the device (1) comprising:
- an electroluminescent component (3), at least semi-transparent in the first spectral range, and comprising first and second opposite surfaces (30, 31), the first surface (30) being intended to be oriented towards the substance (2), the electroluminescent component (3) being suitable for emitting an excitation radiation (Re₁, Re₂) outgoing from the first and second surfaces (30, 31), the excitation radiation (Re₁, Re₂) being emitted in a second spectral range according to a circular polarization state, the excitation radiation (Re₁) being suitable for exciting the substance (2) so that the substance (2) can emit the photoluminescence radiation (Rp);
- a polarization filter (4) associated with the electroluminescent component (3), arranged to filter the excitation radiation (Re₂) outgoing from the second surface (31) of the electroluminescent component (3), and suitable for modifying the circular polarization state so as to obtain an extinguishing of the excitation radiation (Re₂) outgoing from the second surface (31) of the electroluminescent component (3);
- a detector (5), arranged to detect the photoluminescence radiation (Rp) outgoing from the polarization filter (4), the electroluminescent component (3) and the detector (5) being situated on just one side of the substance.

2. Device (1) according to Claim 1, wherein the polarization filter (4) comprises:
- a quarter-wave plate (40), arranged to modify the circular polarization state of the excitation radiation (Re₂) outgoing from the second surface (31) of the electroluminescent component (3) to a linear polarization state having a first polarization direction;
- a linear polarizer (41), having a polarization axis at right angles to the first polarization direction, and arranged to obtain the extinguishing of the excitation radiation (Re₂) outgoing from the quarter-wave plate (40).

3. Device (1) according to Claim 1 or 2, wherein the substance (2) comprises several types of elements (20) capable of emitting the photoluminescence radiation (Rp) at predetermined distinct wavelengths; and the device (1) comprises optical spectral filters (6), suitable for filtering the photoluminescence radiation (Rp) at the predetermined distinct wavelengths, and arranged between the polarization filter (4) and the detector (5), the optical spectral filters (6) being preferably coloured filters arranged in a Bayer matrix.

4. Device (1) according to one of Claims 1 to 3, wherein the electroluminescent component (3) is chosen from among:
- an organic electroluminescent component (3), preferably comprising organic light-emitting diodes;
- an inorganic electroluminescent component (3), preferably comprising light-emitting diodes of spin-LED type.

5. Device (1) according to one of Claims 1 to 4, wherein the detector (5) comprises photodiodes (50).

6. Device according to one of Claims 1 to 5, wherein the excitation radiation (Re₁) is suitable for exciting the substance (2) comprising elements (20) chosen from among fluorescent quantum dots and organic fluorophores.

7. System for characterizing a substance (2) capable of emitting a photoluminescence radiation (Rp) in a first spectral range, the system comprising:
- a device (1) according to one of Claims 1 to 6;
- a separating wall (P), intended to separate the substance (2) and the device (1), the separating wall (P) being at least semi-transparent in the first and second spectral ranges;
the first surface (30) of the electroluminescent component (3) being mounted on the separating wall (P).

8. Assembly for characterizing a substance (2) capable of emitting a photoluminescence radiation (Rp) in a first spectral range, the assembly comprising:
- a device (1) according to one of Claims 1 to 6;
- a container (7), intended to receive the substance (2), and comprising first and second opposite walls (70, 71) that are at least semi-transparent in the first and second spectral ranges; the first surface (30) of the electroluminescent component (3) being mounted on the first wall (70);
- an absorber (8), arranged on the second wall (71), and suitable for absorbing the excitation radiation (Re₁) outgoing from the first surface (30) of the electroluminescent component (3) and passing through the first and second walls (70, 71).

9. Assembly for characterizing a substance (2) capable of emitting a photoluminescence radiation (Rp) in a first spectral range, the assembly comprising:
- a device (1) according to one of Claims 1 to 6;
- a container (7), intended to receive the substance (2), and comprising first and second opposite walls (70, 71) that are at least semi-transparent in the first and second spectral ranges; the first surface (30) of the electroluminescent component (3) being mounted on the first wall (70);
- an additional polarization filter (4'), arranged to filter the excitation radiation outgoing from the second wall (71), and suitable for modifying the circular polarization state so as to obtain an extinguishing of the excitation radiation outgoing from the second wall (71);
- an additional detector (5'), arranged to detect the photoluminescence radiation (Rp) outgoing from the additional polarization filter (4').
